(19) Europäisches Patentamt
European Patent Office
Office européen des brevets

(11) **EP 1 550 349 B1**

(12) **EUROPÄISCHE PATENTSCHRIFT**

(45) Veröffentlichungstag und Bekanntmachung des Hinweises auf die Patenterteilung:
**08.01.2014 Patentblatt 2014/02**

(21) Anmeldenummer: **03753536.6**

(22) Anmeldetag: **09.10.2003**

(51) Int Cl.:
***H04R 19/00*** *(2006.01)*

(86) Internationale Anmeldenummer:
**PCT/EP2003/011204**

(87) Internationale Veröffentlichungsnummer:
**WO 2004/036952 (29.04.2004 Gazette 2004/18)**

(54) **MEMBRAN UND VERFAHREN ZU DEREN HERSTELLUNG**

MEMBRANE AND METHOD FOR THE PRODUCTION THEREOF

MEMBRANE ET PROCEDE DE REALISATION ASSOCIE

(84) Benannte Vertragsstaaten:
**DE FR GB IT**

(30) Priorität: **11.10.2002 DE 10247487**

(43) Veröffentlichungstag der Anmeldung:
**06.07.2005 Patentblatt 2005/27**

(73) Patentinhaber: **Infineon Technologies AG**
**85579 Neubiberg (DE)**

(72) Erfinder:
• **DEHE, Alfons**
**85375 Neufahrn (DE)**
• **BARZEN, Stefan**
**81735 München (DE)**
• **FUELDNER, Marc**
**85579 Neubiberg (DE)**

(74) Vertreter: **Zimmermann, Tankred Klaus et al**
**Schoppe, Zimmermann, Stöckeler & Zinkler**
**Patentanwälte**
**Postfach 246**
**82043 Pullach bei München (DE)**

(56) Entgegenhaltungen:
**US-A- 5 573 679**

• **ZOU Q ET AL: "DESIGN AND FABRICATION OF SILICON CONDENSER MICROPHONE USING CORRUGATED DIAPHRAGM TECHNIQUE" JOURNAL OF MICROELECTROMECHANICAL SYSTEMS, IEEE INC. NEW YORK, US, Bd. 5, Nr. 3, 1. September 1996 (1996-09-01), Seiten 197-203, XP000636781 ISSN: 1057-7157**

## Beschreibung

Die vorliegende Erfindung bezieht sich auf eine Membran und auf ein Verfahren zum Herstellen derselben, und hier insbesondere auf eine Membran mit Korrugationsrillen und Antihaftelementen sowie auf ein Verfahren zur Herstellung derselben. Insbesondere bezieht sich die vorliegende Erfindung auf eine Membran für ein Mikrophon, beispielsweise ein Siliziummikrophon.

Zentrales Element eines mikromechanisch realisierten Silizium-Mikrophons ist die darin verwendete Membran, die in dem Schallfeld schwingen soll. Eine Voraussetzung für diese Membran ist, dass diese möglichst empfindlich sein soll, sie darf jedoch bei starken Auslenkungen und einer daraus resultierenden Berührung mit einer Gegenelektrode nicht an der Gegenelektrode haften bleiben. Solche starken Auslenkungen werden beispielsweise durch hohe Schallpegel, eine elektrostatische Anziehung oder die Oberflächenspannung von Flüssigkeiten verursacht.

Im Stand der Technik sind verschiedene Ansätze bekannt, um zum einen die Empfindlichkeit der Membran zu verbessern, und um zum anderen die Anhaftung der Membran zu vermeiden.

Ein Ansatz zur Optimierung der Empfindlichkeit besteht darin, die Schichteigenschaften und den lateralen Entwurf der Membran zu optimieren, beispielsweise durch sogenannte Federmembranen. Der Nachteil dieses Ansatzes besteht jedoch darin, dass durch die sich aufgrund der Optimierung ergebende verringerte Fläche der Membran auch gleichzeitig die Kapazität der Membran sinkt.

Ein weiterer Ansatz zur Verbesserung der Empfindlichkeit einer Membran für ein Silizium-Mikrophon besteht darin, soge-nannte  Korrugationsrillen in der Membran vorzusehen. Ein solcher Ansatz wird beispielsweise von Zou, Quanbo et al. in "Design and Fabrication of Silicon Condenser Microphone Using Corrugated Diaphragm Technique" in Journal of Microelectromechanical Systems, Vol. 5, Nr. 3, September 1996 beschrieben. Gemäß diesem Ansatz werden V-förmige Gräben in einem Siliziumsubstrat gebildet, um bei der nachfolgenden Ausbildung der Membran die erwünschten Korrugationsrillen zu erzeugen.

Ein Ansatz zur Vermeidung von einem irreversiblen Ankleben der Membran an einer Gegenelektrode besteht darin, sogenannte Antihaftelemente (Antisticken Bumps/Dimples) herzustellen. Bei diesen Antihaftelementen handelt es sich um nadelartige Strukturen in der Membran, die die Kontaktfläche bei einer Berührung mit der Gegenelektrode deutlich reduzieren, wie dies von Brauer, et al. in "Silicon Microphone Based on Surface and Bulk Micromachining", Journal of Micromechanics and Microengineering, 11 (2001) Seiten 319-322 beschrieben wird, oder wie dies von Quanbo Zou, et al. in "Design and fabrication of Silicon Condenser Microphone Using Corrugated Diaphragm Technique", September 1996 gezeigt wird. Der Nachteil dieses Ansatzes besteht darin, dass die Herstellung der nadelartigen Strukturen zusätzlichen Prozessaufwand bedeutet.

Hinsichtlich der im Stand der Technik bekannten Lösungen ist festzuhalten, dass diese unabhängige Prozesse lehren, um zum einen die Antihaftelemente zu erzeugen und zum anderen die Empfindlichkeit der Membran zu erhöhen.

Ausgehend von diesem Stand der Technik liegt der vorliegenden Erfindung die Aufgabe zugrunde, ein verbessertes Verfahren zur Herstellung einer Membran sowie ein verbessertes Bauelement zu schaffen, wobei mit reduziertem prozesstechnischen Fertigungsaufwand sowohl eine Empfindlichkeit der Membran verbessert werden kann, als auch das Anhaften der Membran an einer Gegenelektrode vermieden wird.

Diese Aufgabe wird durch ein Verfahren nach Anspruch 1 und ein Bauelement nach Anspruch 10 gelöst.

Die vorliegende Erfindung schafft ein Verfahren zur Herstellung einer Membran für ein Bauelement, mit folgenden Schritten:

(a) Bereitstellen eines Substrats, auf dem eine Gegenelektrode angeordnet ist, wobei auf der dem Substrat abgewandten Oberfläche der Gegenelektrode eine Opferschicht angeordnet ist;

(b) Strukturieren der der Gegenelektroden abgewandten Oberfläche der Opferschicht, um eine Mehrzahl von Ausnehmungen in der Oberfläche zu bilden, um gleichzeitig ein oder mehrere Antihaftelemente und eine oder mehrere Korrugationsrillen zu definieren;

(c) Abscheiden eines Membranmaterials auf die strukturierte Oberfläche der Opferschicht; und

(d) Entfernen der Opferschicht, um die Membran zu bilden, die eine oder mehrere Korrugationsrillen und eines oder mehrere Antihaftelemente aufweist.

Gemäß einem bevorzugten Ausführungsbeispiel der vorliegenden Erfindung werden die Antihaftelemente in einem Bereich der Opferschicht definiert, der einem Zentralbereich der Gegenelektrode gegenüberliegt. Die Korrugationsrillen werden bei diesem Ausführungsbeispiel in einem Bereich der Opferschicht definiert, der einem Randbereich der Gegenelektrode gegenüberliegt, so dass bei einer Auslenkung der Membran zu der Gegenelektrode lediglich das eine oder die mehreren Antihaftelemente mit der Gegenelektrode in Kontakt kommen.

Gemäß einem weiteren bevorzugten Ausführungsbeispiel der vorliegenden Erfindung wird nach dem Strukturieren der Opferschicht eine weitere Opferschicht auf der strukturierten O-berfläche abgeschieden, mit einer Dicke, die verglichen mit einer Dicke der Opferschicht gering ist, so dass die strukturierte Oberfläche der Opferschicht in der der Opferschicht abgewandten Oberfläche der weiteren Opferschicht abgebildet ist, wobei dann im Schritt (c) das Membranmaterial auf die strukturierte Oberfläche der weiteren Opferschicht abgeschieden wird und im Schritt (d) zusätzlich die weitere Opferschicht entfernt wird.

Vorzugsweise wird im Schritt (d) die Opferschicht derart entfernt, dass ein Abschnitt der Opferschicht in einem Bereich außerhalb der Gegenelektrode zurückbleibt, um eine Struktur zu definieren, die die Membran beabstandet von der Gegenelektrode trägt.

Vorzugsweise werden die Korrugationsrillen derart strukturiert, dass diese in sich geschlossen sind und die Antihaftelemente umgeben, wobei die Korrugationsrillen kreisförmig, polygonzugmäßig oder in beliebiger Form definiert sein können.

Vorzugsweise haben die Ausnehmungen, die die Antihaftelemente definieren, eine laterale Abmessung, die verglichen mit einer lateralen Abmessung der Ausnehmungen, die die Korrugationsrillen definieren, klein sind, so dass beim Abscheiden des Membranmaterials oder der weiteren Opferschicht die Ausnehmungen, die die Antihaftelemente definieren, wieder ganz oder nahezu ganz - je nach gewünschter Form des Bumps - verschlossen werden.

Die vorliegende Erfindung schafft ferner ein Bauelement gemäß Anspruch 10.

Vorzugsweise handelt es sich bei dem Bauelement um ein Mikrophon, beispielsweise ein Siliziummikrophon, und die Membran ist die Mikrophonmembran. Alternativ kann es sich bei dem Bauelement auch um einen Drucksensor handeln.

Der Vorteil der vorliegenden Erfindung besteht darin, dass die Empfindlichkeit nun durch eine oder mehrere Korrugationsrillen in der Membran verbessert wird, wobei Korrugationsrillen eine vertikale umlaufende Wellenstruktur in der Membran bilden. Erfindungsgemäß wird hierfür in der Opferoxidschicht, die den Spaltabstand im Kondensermikrophon bestimmt, eine oder mehrere Ringstrukturen (Korrugationsrillen) und eine oder mehrere Lochstrukturen (Bumps, Antihaftelemente) definiert, die sich bei der Abscheidung der Membran in diese abformen, und so die erwünschte Struktur ergeben.

Erfindungsgemäß wird eine Verbesserung des Herstellungsverfahrens dadurch erreicht, dass gleichzeitig die Korrugationsrillen und die Antihaftelemente in einem Arbeitsschritt hergestellt werden, so dass die Nachteile im Stand der Technik, welche für die Herstellung der Korrugationsrillen und für die Herstellung der Antihaftelemente jeweils unterschiedliche Verfahren und Herstellungsprozesse benötigten, vermieden werden.

Ein Vorteil der vorliegenden Erfindung besteht darin, dass Korrugationsrillen nun mit der gleichen Technologie erzeugt werden, mit der bisher auch schon die Antihaftelemente erzeugt wurden, so dass erfindungsgemäß keine zusätzlichen Prozessschritte erforderlich sind.

Da die Fläche der Membran zur Erhöhung der Empfindlichkeit nicht strukturiert und damit verkleinert wird, verbleibt die Kapazität in vollem Umfang erhalten.

Die Empfindlichkeitssteigerung der erfindungsgemäßen korrugierten Membran ist vergleichbar mit der, wie sie bei Federmembranen erreicht wird, kann jedoch zusätzlich durch die Anzahl der Korrugationsrillen eingestellt werden.

Bevorzugte Ausführungsbeispiele der vorliegenden Erfindung werden nachfolgend anhand der beiliegenden Zeichnungen näher erläutert. Es zeigen:

Fig. 1A bis 1D ein Ausführungsbeispiel zur Herstellung einer Mikrophonmembran gemäß der vorliegenden Erfindung;

Fig. 2A eine Draufsicht auf die gemäß den in Fig. 1 beschriebenen Verfahren hergestellte Mikrophonmembran;

Fig. 2B eine Detailansicht eines Ausschnitts der in Fig. 2A gezeigten Membran;

Fig. 3 einen Graphen, der die Verbesserung der Empfindlichkeit der erfindungsgemäßen Mikrophonmembran abhängig von der Anzahl der Korrugationsrillen anzeigt;

Fig. 4A eine Darstellung einer Korrugationsmembran mit den für die Bestimmung der Empfindlichkeit erforderlichen Parameter; und

Fig. 4B eine Querschnittsdarstellung einer Korrugationsrille der Membran aus Fig. 4A.

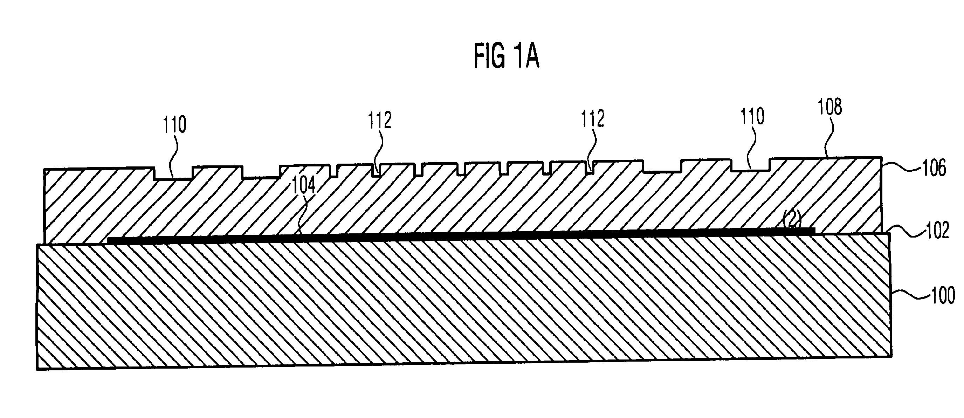

Nachfolgend wird ein Ausführungsbeispiel der vorliegenden Erfindung zur Herstellung eines Siliziummikrophons anhand der Fig. 1A bis 1D näher erläutert, wobei im folgenden die Herstellung einer Membran mit Antihaftelementen (Bumps) und Korrugationsrillen dargestellt wird. Die Membran kann Teil eines kapazitiven Mikrophons sein, wobei die Membran dann eine Elektrode des Plattenkondensators bildet, und eine zweite statische Elektrode unter derselben angeordnet ist.

In Fig. 1A ist ein Substrat 100 gezeigt, welches eine erste Hauptoberfläche 102 aufweist. Auf der Hauptoberfläche 102 des Substrats 100 ist zumindest teilweise eine Gegenelektrode 104 gebildet. Auf einer dem Substrat 100 abgewandten Oberfläche der Gegenelektrode 104 ist eine erste Opferoxidschicht 106 angeordnet, wobei diese bei dem in Fig. 1A gezeigten Ausführungsbeispiel derart gebildet ist, dass diese die Gegenelektrode 104 vollständig bedeckt und ferner auf die erste Hauptoberfläche 102 des Substrats 100 reicht.

In einer dem Substrat 100 abgewandten Oberfläche 108 der ersten Opferoxidschicht 106 sind eine erste Mehrzahl von Ausnehmungen 110 sowie eine zweite Mehrzahl von Ausnehmungen 112 gebildet, wobei in Fig. 1A der Übersichtlichkeit halber lediglich einzelne der Ausnehmungen mit einem Bezugszeichen versehen sind. Die Ausnehmungen 110, 112 werden durch einen geeigneten Ätzvorgang in die Oberfläche 108 der ersten Opferoxidschicht 106 eingebracht, wobei die Ausnehmungen 110 strukturiert sind, um die Strukturen für die in der Membran zu bildenden Korrugationsrillen zu definieren. Die Ausnehmungen 112 sind definiert, um die Strukturen für die in der Membran vorgesehenen Antihaftelemente zu definieren. Die laterale Geometrie der Ausnehmungen 110, 112 ist derart gewählt, dass die Ausnehmungen 112 für die Definition der Antihaftelemente so schmal sind, beispielsweise im Bereich von 1 $\mu$m, dass diese Ausnehmungen 112 bei einer nachfolgenden OxidAbscheidung, beispielsweise mit einer Dicke von etwa 600 nm, nahezu wieder geschlossen werden. Die laterale Abmessung der Ausnehmungen 112 liegt somit in etwa im Bereich der Dicke der nachfolgend aufzubringenden Oxidschicht. Demgegenüber sind die Ausnehmungen 110 zur Festlegung der Korrugationsrillen  deutlich breiter ausgelegt, als die Dicke einer nachfolgenden, durch eine Oxidabscheidung erzeugten Schicht, wobei die Abmessung der Ausnehmungen 110 beispielsweise 5 $\mu$m betragen kann.

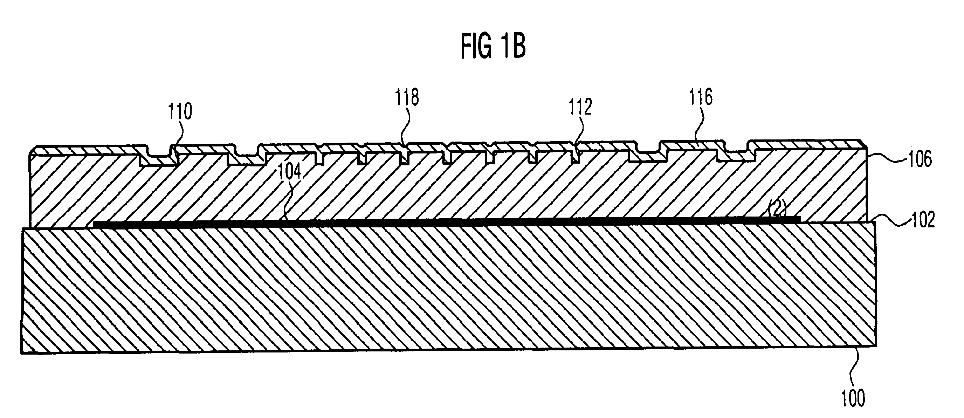

Wie in Fig. 1B gezeigt ist, wird auf die strukturierte Oberfläche 108 der ersten Opferoxidschicht eine zweite Opferoxidschicht 116 aufgebracht, um die Struktur, wie sie in Fig. 1A gezeigt ist, zu verrunden. Die Dicke der zweiten Opferoxidschicht 116 ist, verglichen mit der Dicke der ersten Opferoxidschicht gering, und beträgt bei dem dargestellten Ausführungsbeispiel etwa 600 nm. Wie oben anhand der Fig. 1A beschrieben wurde, sind die Abmessungen der Ausnehmungen 112 zur Definition der an die Haftelemente derart gewählt, dass die laterale Abmessung der Ausnehmungen 112 im Bereich der Dicke der weiteren Opferoxidschicht 116 liegt. Dies führt dazu, dass nach dem Abscheiden der zweiten Opferoxidschicht 116 von den Ausnehmungen 112, den sogenannten Bump-Löchern, nur eine spitze Vertiefung verbleibt, wie dies in Fig. 1B durch das Bezugszeichen 118 gezeigt ist.

Aufgrund der Abmessung der Ausnehmungen 110 zur Definition der Korrugationsrillen in der Oberfläche 108 der ersten Opferoxidschicht 106, welche deutlich größer ist als die Dicke der Oxidschicht 116, ergibt sich eine entsprechende Abbildung der Ausnehmungen 110 in die zweite Opferoxidschicht 116.

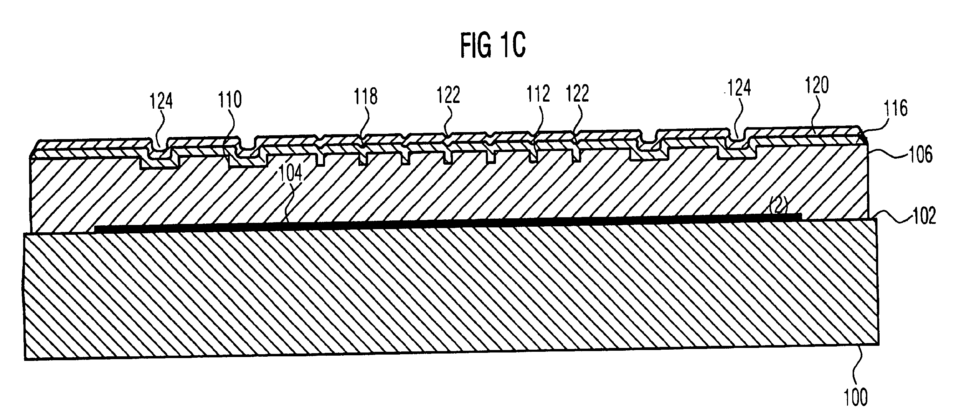

In einem nachfolgenden Schritt, wie er in Fig. 1C gezeigt ist, wird nun das Membranmaterial abgeschieden, um die Membran 120 zu erzeugen. Das Membranmaterial zur Erzeugung der Membran 120 wird bei dem dargestellten Ausführungsbeispiel mit einer Dicke von z. B. 200 nm abgeschieden. Wie in Fig. 1C durch das Bezugszeichen 122 dargestellt ist, werden die in der zweiten Opferoxidschicht 116 gebildeten Vertiefungen 118 bei der Abscheidung des Membranmaterials auch in die Membran 120 abgebildet. Gleichzeitig bilden sich aufgrund der Abscheidung unter Definition der Ausnehmungen 110 in der Oberfläche  der ersten Opferoxidschicht 106 die Korrugationsrillen 124 in der Membran.

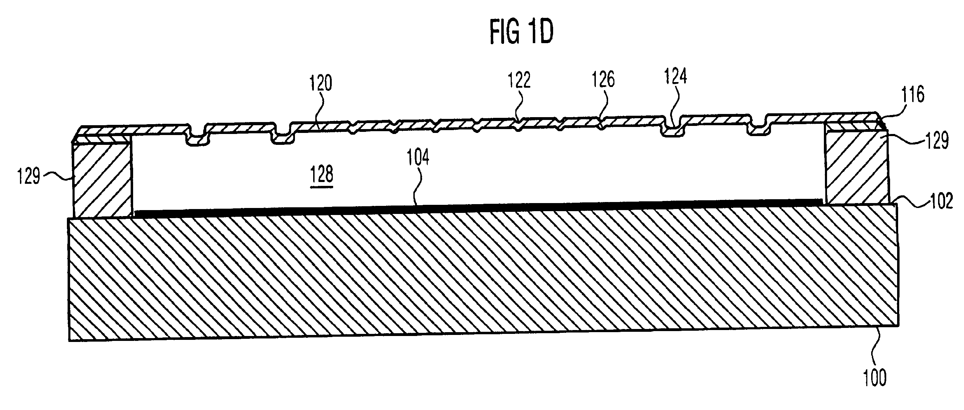

1. In einem abschließenden Verfahrensschritt, werden die erste Opferoxidschicht 106 und die zweite Opferoxidschicht 116 teilweise entfernt, beispielsweise durch einen geeigneten Ätzprozess, so dass sich die in Fig. 1D dargestellte Struktur mit einem Hohlraum 128 zwischen der Membran 120 und dem Substrat 100 bzw. der Gegenelektrode 104 ergibt. Die Opferschichten 106 und 116 werden derart entfernt, dass ein Abschnitt der Opferschichten in einem Bereich außerhalb der Gegenelektrode 104 zurückbleibt, um eine Struktur 129 zu definieren, die die Membran 120 beabstandet von der Gegenelektrode 104 trägt. Wie in Fig. 1D zu erkennen ist, ergibt sich aufgrund der Entfernung der Opferoxidschichten 106, 116 die Anordnung mit der Membran 120, welche die Korrugationsrillen 124 sowie eine Mehrzahl von Antihaftelementen (Anti-Sticking-Bumps) 126 umfasst.

Erfindungsgemäß wurde somit auf einfache Art und Weise eine Mikrophonmembran erzeugt, die zum einen aufgrund der Korrugationsrillen eine verbesserte Empfindlichkeit aufweist und zum anderen bei einer Auslenkung gegen die Gegenelektrode nicht an derselben anhaftet, aufgrund der vorgesehenen Antihaftelemente. Wie oben beschrieben wurde, liegt der erfindungsgemäße Vorteil darin, dass keine verschiedenen Herstellungsprozesse zur Erzeugung der Korrugationsrillen und der Antihaftelemente erforderlich sind, sondern vielmehr diese, erfindungsgemäß, in einem gemeinsamen Herstellungsschritt erzeugt werden.

Bei dem in Fig. 1 dargestellten Ausführungsbeispiel ergibt sich eine Struktur, welche ein Siliziummikrophon bildet, bei dem die Antihaftelemente in einem Zentralbereich der Membran 120 angeordnet sind, wobei die Korrugationsrillen 124 in einem Randbereich der Membran 120 angeordnet sind, der den Zentralbereich mit den Antihaftelementen umgibt und ferner mit der Tragestruktur 129 verbunden ist. Diese Struktur führt dazu, dass bei einer starken Auslenkung der Membran 120 der Zentralbereich mit den Antihaftelementen 126 so weit ausgelenkt werden kann, dass dieser in Kontakt mit der Gegenelektrode 104 gelangt, wobei hier dann eine Anhaftung vermieden wird, da die Kontaktfläche aufgrund der vorgesehenen Antihaftelemente 126 ausreichend reduziert ist.

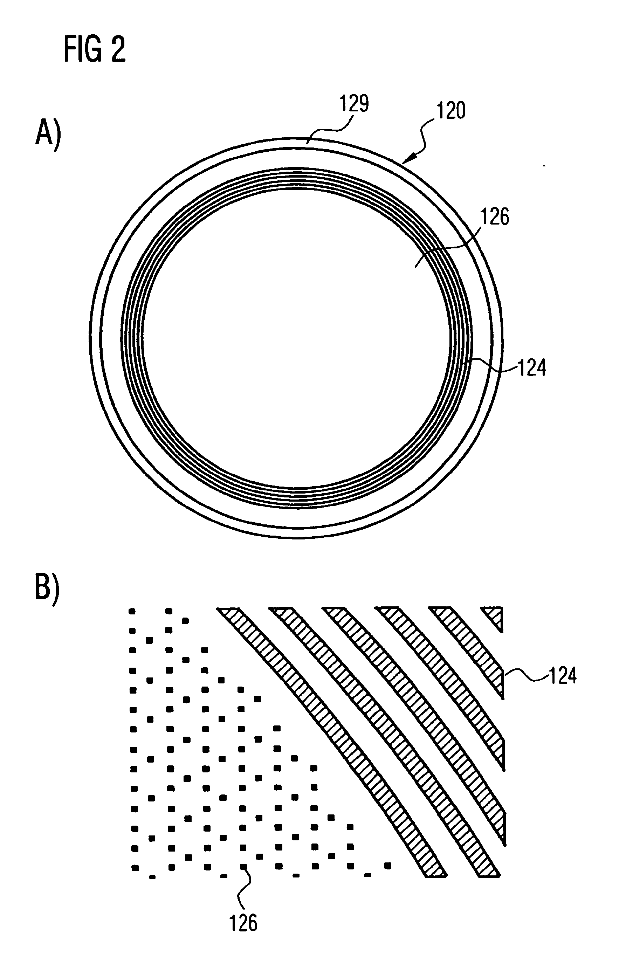

In Fig. 2A ist eine Draufsicht der Membran 120 gezeigt, die gemäß dem in Fig. 1 beschriebenen Verfahren hergestellt wurde.

Wie in Fig. 2A zu erkennen ist, ist die Membran 120 sowie die Tragestruktur 129 kreisförmig ausgeführt, und ebenso das in Fig. 2A nicht dargestellte Substrat. Die sechs Korrugationsrillen 124 im Randbereich der Membran 120 sind kreisförmig gebildet und in sich geschlossene Strukturen, wobei die innere Korrugationsrille die Antihaftelemente 126 im Zentralbereich der Membran 120 umgibt.

Fig. 2B ist eine vergrößerte Darstellung der in Fig. 2A gezeigten Membran mit den Korrugationsrillen 124 und den Bumps 126. Die Korrugationsrillen haben eine Breite von etwa 5μm, und die Bumps haben eine Breite von etwa 1μm. Vorzugsweise umfasst die Gegenelektrode eine Mehrzahl von Öffnungen, und die Anordnung der Bumps ist passend zu diesen Öffnungen.

Die vorliegende Erfindung, wie sie oben anhand des bevorzugten Ausführungsbeispiels in Fig. 1 und 2 beschrieben wurde, ist nicht auf diese Ausführungsbeispiele beschränkt. Vielmehr kann die Membran 120 auch andere Formen, z. B. rechteckige Formen, annehmen, und ebenso sind die Korrugationsrillen 124 nicht auf die beschriebene kreisförmige Ausgestaltung beschränkt. Die Korrugationsrillen können vielmehr auch durch einen Polygonzug oder durch mehrere, voneinander getrennte Abschnitte gebildet sein.

Ferner wurde bei dem oben beschriebenen Ausführungsbeispiel dargelegt, dass auf die erste Opferschicht eine zweite Opferoxidschicht 116 aufgebracht wird. Bei einem anderen Ausführungsbeispiel, kann die Membran auch direkt auf die erste Opferoxidschicht 106 aufgebracht werden.

Obwohl die Beschreibung der obigen Ausführungsbeispiele anhand eines Siliziummikrophons erfolgte, wird darauf hingewiesen, dass die vorliegende Erfindung nicht auf diese Anwendung beschränkt ist. Vielmehr ist die vorliegende Erfindung für alle Bauelemente geeignet, bei denen eine Membran vorgesehen ist, welche eine bestimmte Empfindlichkeit aufweisen muss, und bei der eine Anhaftung auf einer Gegenelektrode zu vermeiden ist. Andere Einsatzgebiete umfassen beispielsweise Drucksensoren oder ähnliches.

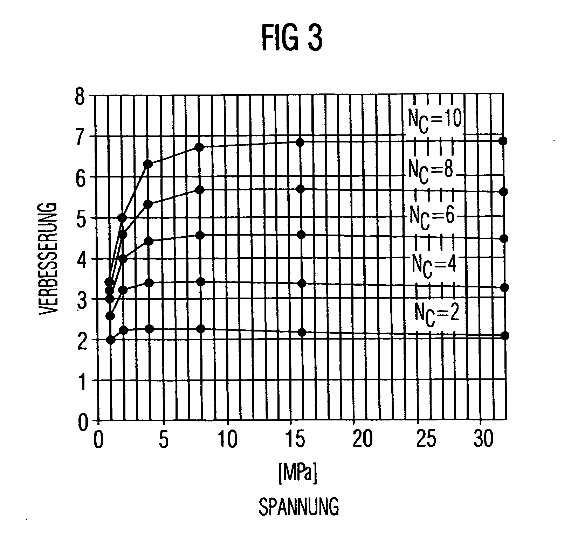

Nachfolgend wird anhand der Fig. 3 näher erläutert, auf welche Art und Weise sich eine Verbesserung der Empfindlichkeit einer Membran aufgrund der Korrugationsrillen erreicht wird. Die Membranschicht 120 steht unter Zugspannung, welche die Empfindlichkeit der Membran 120 wesentlich bestimmt. Die Korrugationsrille dient zur Relaxation dieser Schichtspannung. Dabei kann gezeigt werden, dass die Steigerung der Empfindlichkeit in weiten Bereichen proportional zur Anzahl der eingebrachten Korrugationsrillen $N_c$ verläuft. In der in Fig. 3 dargestellten Graphik, welche auf einer FEM-Analyse (FEM = Finite Elemente Methode) beruht, ist die Empfindlichkeitssteigerung bezogen auf diejenige einer Kreismembran 120, wie sie beispielsweise in Fig. 2 gezeigt ist, dargestellt. Wie aus der in Fig. 3 gezeigten Darstellung zu entnehmen ist, kann hier bereits durch Verwendung von nur zwei Korrugationsrillen ($N_c$ = 2) die Empfindlichkeit verdoppelt werden.

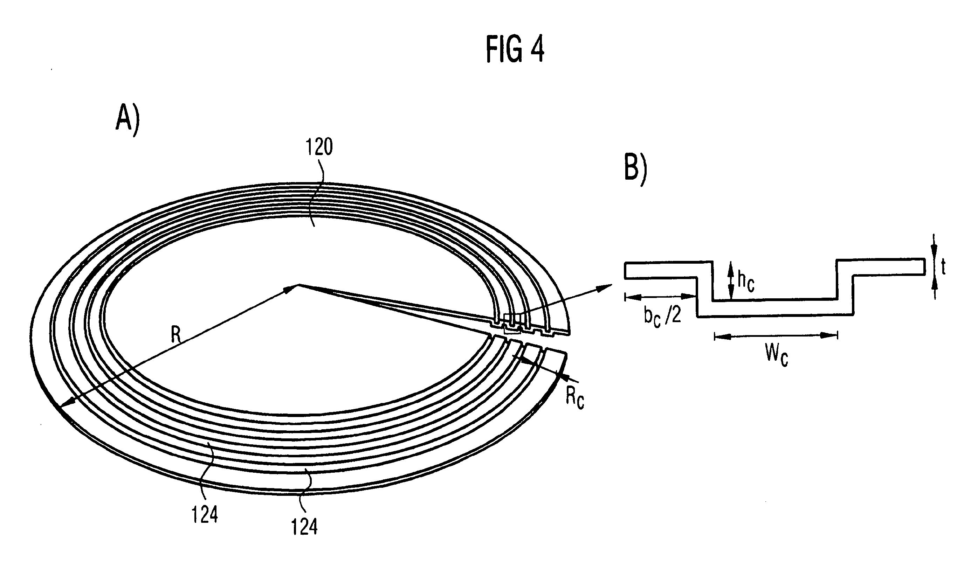

Für eine genauere Beschreibung der Empfindlichkeit einer Korrugationsmembran, muss deren Geometrie betrachtet werden. In Fig. 4A ist eine kreisförmige Korrugationsmembran, ähnlich der in Fig. 2 gezeigten, wiedergegeben, wobei in Fig. 4A der Radius R der Membran 120 eingezeichnet ist. Bei dem in Fig. 4A gezeigten Ausführungsbeispiel umfasst die Membran vier Korrugationsrillen 124. Ferner ist in Fig. 4A der Abstand $R_c$ zwischen einem Rand der Korrugationsmembran 120 sowie der zum Rand benachbart liegenden, ersten Korrugationsrille wiedergegeben, also der Abstand zwischen der äußersten Korrugationsrille und dem Rand der Membran 120.

In Fig. 4B ist ein Querschnitt einer Korrugationsrille, wie sie in Fig. 4A gebildet ist, dargestellt, wobei $w_c$ die Breite der Korrugationsrille angibt, $h_c$ die Tiefe der Korrugationsrille angibt, t die Dicke der Membran 120 angibt, und $b_c/2$ die Hälfte des Abstandes der betrachteten Korrugationsrille zu der benachbarten Korrugationsrille wiedergibt.

Mit der oben beschriebenen Notation, wie sie auch in der Fig. 4 wiedergegeben ist, kann eine Beziehung für die effektive Spannung $\sigma_c$ in der Membran 120 in Fig. 4A wie folgt angegeben werden:

$$\sigma_c = \frac{\sigma_0}{1 + 2{,}55 \cdot \dfrac{h_c^2}{t^2} \cdot \dfrac{(b_c + w_c) \cdot N_c}{R - R_c - (b_c + w_c) \cdot N_c}}$$

In der obigen Gleichung bezeichnet $\sigma_0$ die Schichtspannung des Membranmaterials. Wie aus der Gleichung zu entnehmen ist, beruht die Erhöhung der Empfindlichkeit einer korrugierten Membran also auf einer niedrigeren effektiven mechanischen Spannung in der Membran 120.

Bezugszeichenliste

| | |
|---|---|
| 100 | Substrat |
| 102 | Oberfläche des Substrats |
| 104 | Gegenelektrode |
| 106 | erste Oxidschicht |
| 108 | Oberfläche der ersten Opferoxidschicht |
| 110 | erste Mehrzahl von Ausnehmungen |
| 112 | zweite Mehrzahl von Ausnehmungen |
| 116 | zweite Opferoxidschicht |
| 118 | Vertiefungen der zweiten Opferoxidschicht |
| 120 | Membran |
| 122 | Vertiefung in der Membran |
| 124 | Korrugationsrillen |
| 126 | Antihaftelemente |
| 128 | Hohlraum |
| 129 | Tragestruktur |

**Patentansprüche**

1. Verfahren zur Herstellung einer Membran (120) für ein Bauelement, mit folgenden Schritten:

   (a) Bereitstellen eines Substrats (100), auf dem eine Gegenelektrode (104) angeordnet ist, wobei auf einer dem Substrat (100) abgewandten Oberfläche der Gegenelektrode (104) eine Opferschicht (106) angeordnet ist;
   (b) Strukturieren der der Gegenelektrode (104) abgewandten Oberfläche (108) der Opferschicht (106), um eine Mehrzahl von Ausnehmungen (110, 112) in der Oberfläche zu bilden, um gleichzeitig ein oder mehrere Antihaftelemente und eine oder mehrere Korrugationsrillen zu definieren;
   (c) Abscheiden eines Membranmaterials (120) auf die strukturierte Oberfläche (108) der Opferschicht (106); und
   (d) Entfernen der Opferschicht (106), um die Membran (120) zu bilden, die eine oder mehrere Korrugationsrillen (124) und eines oder mehrere Antihaftelemente (126) aufweist.

2. Verfahren nach Anspruch 1, bei dem im Schritt (b) die Antihaftelemente in einem Bereich der Opferschicht (106) definiert werden, der einem Zentralbereich der Gegenelektrode (104) gegenüberliegt, und bei dem die Korrugationsrillen in einem Bereich der Opferschicht (106) definiert werden, der einem Randbereich der Gegenelektrode (104) gegenüberliegt, so dass bei einer Auslenkung der Membran (120) zu der Gegenelektrode (104) lediglich das eine oder die mehreren Antihaftelemente (126) mit der Gegenelektrode (104) in Kontakt kommen.

3. Verfahren nach Anspruch 1 oder 2, das zwischen dem Schritt (b) und dem Schritt (c) folgende Schritte umfasst:

   Abscheiden einer weiteren Opferschicht (116) auf der strukturierten Oberfläche (108) der Opferschicht (106) mit einer Dicke, die verglichen mit einer Dicke der Opferschicht (106) gering ist, so dass die strukturierte Oberfläche (108) der Opferschicht (106) in der der Opferschicht (106) abgewandten Oberfläche der weiteren Opferschicht (116) abgebildet wird,
   wobei im Schritt (c) das Membranmaterial (120) auf die strukturierte Oberfläche der weiteren Opferschicht (116) abgeschieden wird, und
   wobei im Schritt (c) zusätzlich die weitere Opferschicht (116) entfernt wird.

4. Verfahren nach einem der Ansprüche 1 bis 3, bei dem im Schritt (d) die Opferschicht (106) derart entfernt wird, dass ein Abschnitt (129) der Opferschicht (106) in einem Bereich außerhalb der Gegenelektrode (104) zurückbleibt, um eine Struktur zu definieren, die die Membran (120) beabstandet von der Gegenelektrode trägt.

5. Verfahren nach einem der Ansprüche 1 bis 4, bei dem die Opferschicht (106) im Schritt (b) strukturiert wird, um in sich geschlossene Korrugationsrillen zu definieren, die Antihaftelemente umgeben.

6. Verfahren nach Anspruch 5, bei dem die Korrugationsrillen (124) kreisförmig oder polygonzugmäßig definiert werden.

**7.** Verfahren nach einem der Ansprüche 1 bis 6, bei dem die Ausnehmungen (112), die die Antihaftelemente definieren, eine laterale Abmessung aufweisen, die verglichen mit einer lateralen Abmessung der Ausnehmungen (110), die die Korrugationsrillen definieren, klein ist, so dass beim Abscheiden des Membranmaterials oder der weiteren Opferschicht (116) die Ausnehmungen (112), die die Antihaftelemente definieren, wieder verschlossen werden.

**8.** Verfahren nach einem der Ansprüche 1 bis 7, bei dem das Membranmaterial (120) Silizium ist.

**9.** Verfahren nach einem der Ansprüche 1 bis 8, bei dem das Bauelement ein Mikrophon ist, und bei dem die Membran (120) eine Mikrophonmembran ist.

**10.** Bauelement, mit
einem Substrat (100) mit einer Hauptoberfläche (102),
einer auf dem Substrat (100) angeordneten Gegenelektrode (104), wobei die Gegenelektrode (104) zumindest teilweise auf der Hauptoberfläche (102) des Substrats (100) gebildet ist, wobei eine Oberfläche der Gegenelektrode zu dem Substrat (100) hin gewandt ist;
einer Membran (120), die beabstandet von der Gegenelektrode (104) getragen ist, um der Gegenelektrode (104) gegenüberzuliegen, wobei eine andere Oberfläche der Gegenelektrode, die von dem Substrat abgewandt ist, der Membran (120) gegenüberliegt,
wobei die Membran (120) eines oder mehrere Antihaftelemente (126) in einem Zentralbereich der Membran (120) und eine oder mehrere Korrugationsrillen (124) in einem den Zentralbereich umgebenden Randbereich der Membran (120) aufweist.

**11.** Bauelement nach Anspruch 10, bei der das Bauelement ein Mikrophon ist, und bei dem die Membran (120) eine Mikrophonmembran ist.

**12.** Bauelement nach Anspruch 11, bei dem die eine oder die mehrere Korrugationsrillen (124) als in sich geschlossene Korrugationsrillen ausgebildet sind.

**13.** Bauelement nach Anspruch 11, bei dem die Antihaftelemente (126) als Bumps ausgebildet sind, und bei dem die Gegenelektrode (104) eine Mehrzahl von Öffnungen aufweist, wobei die Bumps passend zu den Öffnungen ausgebildet sind.

**14.** Bauelement nach Anspruch 11, bei dem eine Tiefe ($h_c$) der einen oder der mehreren Korrugationsrillen (124) kleiner als ein Abstand zwischen der Membran und der Gegenelektrode ist.

**15.** Bauelement nach Anspruch 11, bei dem die Hauptoberfläche (102) des Substrats (100) eine ebene Oberfläche ist.

**16.** Bauelement nach Anspruch 11, bei dem die Membran (120) durch eine Tragestruktur (129) getragen wird, wobei die Tragestruktur (129) mit dem Randbereich der Membran (120) verbunden ist und außerhalb der Gegenelektrode auf dem Substrat (100) angeordnet ist.

**17.** Bauelement nach Anspruch 16, bei dem die Tragestruktur (129) aus Oxid besteht.

**Claims**

**1.** Method for producing a membrane (120) for a component, with the following steps:

(a) providing a substrate (100), on which a counterelectrode (104) is arranged, a sacrificial layer (106) being arranged on a surface of the counterelectrode (104) that is facing away from the substrate (100);
(b) structuring the surface (108) of the sacrificial layer (106) that is facing away from the counterelectrode (104), in order to form a plurality of recesses (110, 112) in the surface, in order to define at the same time one or more anti-adherent elements and one or more corrugation grooves;
(c) depositing a membrane material (120) onto the structured surface (108) of the sacrificial layer (106); and
(d) removing the sacrificial layer (106), in order to form the membrane (120), which has one or more corrugation grooves (124) and one or more anti-adherent elements (126).

**2.** Method according to Claim 1, in which the anti-adherent elements are defined in step (b) in a region of the sacrificial layer (106) that lies opposite a central region of the counterelectrode (104), and in which the corrugation grooves are defined in a region of the sacrificial layer (106) that lies opposite a peripheral region of the counterelectrode (104), so that, when there is a deflection of the membrane (120) in relation to the counterelectrode (104), just the one or the multiple anti-adherent elements (126) come into contact with the counterelectrode (104).

3. Method according to Claim 1 or 2, which between step (b) and step (c) comprises the following steps:

depositing a further sacrificial layer (116) on the structured surface (108) of the sacrificial layer (106) with a thickness which is small compared to a thickness of the sacrificial layer (106), so that the structured surface (108) of the sacrificial layer (106) is replicated in the surface of the further sacrificial layer (116) that is facing away from the sacrificial layer (106),
the membrane material (120) being deposited onto the structured surface of the further sacrificial layer (116) in step (c), and
the further sacrificial layer (116) additionally being removed in step (c).

4. Method according to one of Claims 1 to 3, in which the sacrificial layer (106) is removed in step (d) in such a way that a portion (129) of the sacrificial layer (106) in a region outside the counterelectrode (104) is left behind, in order to define a structure that supports the membrane (120) at a distance from the counterelectrode.

5. Method according to one of Claims 1 to 4, in which the sacrificial layer (106) is structured in step (b), in order to define self-contained corrugation grooves that surround anti-adherent elements.

6. Method according to Claim 5, in which the corrugation grooves (124) are defined in a circular form or in the manner of a polyline.

7. Method according to one of Claims 1 to 6, in which the recesses (112) that define the anti-adherent elements have a lateral dimension which is small compared to a lateral dimension of the recesses (110) that define the corrugation grooves, so that, when the membrane material or the further sacrificial layer (116) is deposited, the recesses (112) that define the anti-adherent elements are closed again.

8. Method according to one of Claims 1 to 7, in which the membrane material (120) is silicon.

9. Method according to one of Claims 1 to 8, in which the component is a microphone, and in which the membrane (120) is a microphone diaphragm.

10. Component, comprising
a substrate (100) with a main surface (102),
a counterelectrode (104), arranged on the substrate (100), the counterelectrode (104) being formed at least partially on the main surface (102) of the substrate (100), a surface of the counterelectrode facing the substrate (100);
a membrane (120), which is supported at a distance from the counterelectrode (104), in order to lie opposite the counterelectrode (104), another surface of the counterelectrode that is facing away from the substrate lying opposite the membrane (120),
the membrane (120) having one or more anti-adherent elements (126) in a central region of the membrane (120) and one or more corrugation grooves (124) in a peripheral region of the membrane (120) that surrounds the central region.

11. Component according to Claim 10, in which the component is a microphone, and in which the membrane (120) is a microphone diaphragm.

12. Component according to Claim 11, in which the one or more corrugation grooves (124) are formed as self-contained corrugation grooves.

13. Component according to Claim 11, in which the anti-adherent elements (126) are formed as bumps, and in which the counterelectrode (104) has a plurality of openings, the bumps being formed so as to fit the openings.

14. Component according to Claim 11, in which a depth ($h_c$) of the one or more corrugation grooves (124) is less than a distance between the membrane and the counterelectrode.

**15.** Component according to Claim 11, in which the main surface (102) of the substrate (100) is a planar surface.

**16.** Component according to Claim 11, in which the membrane (120) is supported by a supporting structure (129), the supporting structure (129) being connected to the peripheral region of the membrane (120) and being arranged on the substrate (100) outside the counterelectrode.

**17.** Component according to Claim 16, in which the supporting structure (129) consists of oxide.

**Revendications**

**1.** Procédé de fabrication d'une membrane (120) pour un composant ayant les stades suivantes :

(a) on se procure un substrat (100), sur lequel est disposée une contre électrode (104), une couche (106) sacrificielle étant disposée sur une surface de la contre électrode (104) éloignée du substrat (100) ;
(b) on structure la surface (108), éloignée de la contre électrode (104), de la couche (106) sacrificielle, pour former une multiplicité d'évidements (110, 112) dans la surface, pour définir en même temps un ou plusieurs éléments anti-adhérents et une ou plusieurs rainures d'ondulation ;
(c) on dépose un matériau (120) de membrane sur la surface (108) structurée de la couche (106) sacrificielle ;
(d) on élimine la couche (106) sacrificielle pour former la membrane (120), qui a une ou plusieurs rainures (124) d'ondulation et un ou plusieurs éléments (126) anti-adhérents.

**2.** Procédé suivant la revendication 1, dans lequel dans le stade (b), les éléments anti-adhérents sont définis dans une partie de la couche (106) sacrificielle qui est opposée à une partie centrale de la contre électrode (104), et dans lequel les rainures d'ondulation sont définies dans une partie de la couche (106) sacrificielle qui est opposée à une partie de bord de la contre électrode (104), de sorte que, s'il se produit une déviation de la membrane (120) vers la contre électrode (104), seul l'élément (126) anti-adhérent ou les plusieurs éléments (126) anti-adhérents vient (viennent) en contact avec la contre électrode (104).

**3.** Procédé suivant la revendication 1 ou 2, qui comprend entre le stade (b) et le stade (c), les stades suivants :

dépôt d'une autre couche (116) sacrificielle sur la surface (108) structurée de la couche (106) sacrificielle en une épaisseur qui, par rapport à l'épaisseur de la couche (106) sacrificielle, est petite, de sorte que la surface (108) structurée de la couche (106) sacrificielle reproduit l'autre couche (116) sacrificielle dans la surface éloignée de la couche (106) sacrificielle,
dans lequel dans le stade (c), on dépose le matériau (120) de membrane de la surface structurée de l'autre couche (116) sacrificielle, et
dans lequel dans le stade (c), on élimine en outre l'autre couche (116) sacrificielle.

**4.** Procédé suivant l'une des revendications 1 à 3, dans lequel dans le stade (d), on élimine la couche (106) sacrificielle, de manière à ce qu'il reste une partie (129) de la couche (106) sacrificielle dans une zone à l'extérieur de la contre électrode (104), pour définir une structure qui porte la membrane (120) à distance de la contre électrode.

**5.** Procédé suivant l'une des revendications 1 à 4, dans lequel on structure la couche (106) sacrificielle dans le stade (b) pour définir des rainures d'ondulation fermées en soi, qui entourent des éléments anti-adhérents.

**6.** Procédé suivant la revendication 5, dans lequel les rainures (124) d'ondulation sont définies en forme de cercle ou suivant une ligne polygonale.

**7.** Procédé suivant l'une des revendications 1 à 6, dans lequel les évidements (112) qui définissent les éléments anti-adhérents ont une dimension latérale qui, par rapport à une dimension latérale des évidements (110) qui définissent les rainures d'ondulation, est petite, de sorte que, lors du dépôt du matériau de membrane ou de l'autre couche (116) sacrificielle, les évidements (112) qui définissent les éléments anti-adhérents sont refermés.

**8.** Procédé suivant l'une des revendications 1 à 7, dans lequel le matériau (120) de membrane est du silicium.

**9.** Procédé suivant l'une des revendications 1 à 8, dans lequel le composant est un microphone et dans lequel la membrane (120) est une membrane de microphone.

**10.** Composant comprenant
un substrat (100) ayant une surface (102) principale,
une contre électrode (104) disposée sur le substrat (100), la contre électrode (104) étant formée au moins en partie sur la surface principale du substrat (102), une surface de la contre électrode étant tournée vers le substrat (100) ; une membrane (120), qui est portée à distance de la contre électrode (104) pour faire face à la contre électrode (104), une autre surface de la contre électrode, qui est éloignée du substrat, faisant face à la membrane (120), dans lequel la membrane (120) a un ou plusieurs éléments (126) anti-adhérents dans une partie centrale de la membrane (120), et une ou plusieurs rainures (124) d'ondulation dans une  partie de bord de la membrane (120) entourant la partie centrale.

**11.** Composant suivant la revendication 10, dans lequel le composant est un microphone, et dans lequel la membrane (120) est une membrane de microphone.

**12.** Composant suivant la revendication 11, dans lequel la ou les plusieurs rainures (124) d'ondulation sont constituées sous la forme de rainures d'ondulation fermées en soi.

**13.** Composant suivant la revendication 11, dans lequel les éléments (126) anti-adhérents sont constitués sous la forme de bossage, et dans lequel la contre électrode (104) a une multiplicité d'ouvertures, les bossages étant constitués de manière à s'adapter aux ouvertures.

**14.** Composant suivant la revendication 11, dans lequel une profondeur ($h_c$) de la ou des plusieurs rainures (124) d'ondulation est plus petite qu'une distance entre la membrane et la contre électrode.

**15.** Composant suivant la revendication 11, dans lequel la surface (102) principale du substrat (100) est une surface plane.

**16.** Composant suivant la revendication 11, dans lequel la membrane (120) est portée par une structure (129) portante, la structure (129) portante étant reliée à la partie de bord de la membrane (120) et étant disposée sur le substrat (100) à l'extérieur de la contre électrode.

**17.** Composant suivant la revendication 16, dans lequel la structure (129) portante est en oxyde.

# FIG 1A

# FIG 1B

110     118     112     116

104     (2)

106

102

100

EP 1 550 349 B1

## FIG 1C

EP 1 550 349 B1

# FIG 1D

EP 1 550 349 B1

## FIG 2

A)

B)

# FIG 3

## FIG 4

### A)

### B)

EP 1 550 349 B1

EP 1 550 349 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **VON ZOU, QUANBO et al.** Design and Fabrication of Silicon Condenser Microphone Using Corrugated Diaphragm Technique. *Journal of Microelectromechanical Systems,* September 1996, vol. 5 (3

- **VON BRAUER et al.** Silicon Microphone Based on Surface and Bulk Micromachining. *Journal of Micromechanics and Microengineering,* 2001, vol. 11, 319-322